# EUROPEAN PATENT SPECIFICATION

(11) **EP 1 806 845 B1**
(45) Date of publication and mention of the grant of the patent: **16.10.2013**
(21) Application number: 07000264.7
(22) Date of filing: 08.01.2007
(51) Int. Cl.: H03K 17/97

(54) **Non-contact position sensor with reversible self-adjustment**
Kontaktloser Positionssensor mit reversibler Selbsteinstellung
Capteur de position sans contact doté d'un ajustement réversible automatique

(30) Priority: 10.01.2006 DE 102006001242
(43) Date of publication of application: 11.07.2007
(73) Proprietor: Tyco Electronics AMP GmbH, 64625 Bensheim (DE)
(72) Inventor: Sellien, Kai, 68623 Lampertheim (DE)
(74) Representative: Grünecker, Kinkeldey, Stockmair & Schwanhäusser

(56) References cited:
- WO-A1-01/29515
- DE-A1- 4 303 403
- US-A1- 2004 257 068
- US-B1- 6 472 624
- US-B1- 6 867 680

## Description

The present invention relates to a non-contact position sensor with a detector unit, which has a sensor for producing a sensor signal in response to a geometrical position of a movable indicator element relative to the sensor. In particular, the present invention concerns the kind of position sensor, which is applicable as a proximity switch in place of a mechanical switch.

Particularly in automotive engineering the trend is continuing of replacing at least some conventional mechanical switches by non-contact proximity switches as part of the process of the increasing employment of electronic components in the motor vehicle. Thereby, sensor types working to different physical principles are considered, such as Hall sensors, as well as inductive or capacitive proximity switches. For reliable operation of brake lights during actuation of a brake pedal in a motor vehicle, the use of non-contact proximity switches reacting faster in comparison to mechanical switches is in principle very advantageous. The signal causing the switch-on of the brake lights is triggered by the proximity of a passive indicator element to a detector unit and the trigger level is determined by the absolute position of the passive indicator element.

For the adjustment it is frequently provided to make the position of the passive indicator element adjustable relative to the detector unit. Such types of non-contact brake pedal switches are known, for example, from European patent EP 0751 541 B1 or German utility model DE 296 23 230 U1. However in the case of these known solutions, the disadvantage exists that the adjustment of the indicator element relative to the detector unit is comparatively complex and always needs the feedback via the electrical output signal from the detector unit. Therefore, particularly the assembly operation for mass production is too time and cost intensive.

German patent application DE 10 2004 060898 accordingly proposes an arrangement which proceeds from the idea that a self-adjustment can be achieved if the indicator element is so installed in a final assembled position on an actuating unit by means of an assembly apparatus that its geometrical position can be changed by the actuating unit and in a pre-assembled position is fixed to the detector unit in such a manner that the location of the indicator element corresponds to an exactly defined position relative to the sensor. The self-adjustment is achieved here by the fact that the indicator element is only then mounted on the actuating unit when the actuating unit has taken up a likewise exactly defined position, for example, a rest position relative to the detector unit. In this manner, the electrical signal from the sensor need not be used for adjustment of the indicator element thus considerably simplifying the assembly. Furthermore, using this mechanical self-adjustment, a time consuming optimisation process can be avoided and despite that a good switching accuracy be assured.

The U-shaped assembly apparatus shown in this document which is pushed via the actuating unit for assembly has however the disadvantage that the detector unit is fixed stationarily on an assembly plate, for example, in the footwell of a vehicle, whereas it is often desirable to secure the proximity switch in a pre-mounted position on the pedal block. Furthermore, the arrangement shown in DE 10 2004 060898 has the disadvantage that if a re-adjustment is required the indicator element can only be returned to the defined starting state of the pre-assembled position with great difficulty.

German Publication DE 198 03 360 A1 discloses a method for the assembly of a position measuring device as well as the apparatus for carrying out this method in which a magnetic orienting element with a stop is provided, the magnetic orienting element cooperating with a stop face of the solid measure and a stop face of the scanning unit and being removed in the oriented position. This solution has however the disadvantage that separate parts are required for the assembly and over and above that it is only usable for angle sensors.

US 6,531,667 B2 discloses a pedal displacement sensor for ascertaining a pedal displacement position. The pedal displacement sensor contains at least an actuating lever and a switching element. In this manner, the actuating lever is mounted in a housing positioned on a rotational axis and can be rotated by a pedal. The actuating element of the switching element is actuated by rotating the actuating lever. A pedal displacement sensor housing has a housing opening which makes exterior access possible to a region located outside the region of the actuating lever in order to subject the actuating lever to the influence of a pedal movement. The actuating lever is preferably constructed as an angle lever which is rotatable at its first arm end and mounted in the housing. The end region of the second lever arm exits with its end face from the housing opening where the pedal lever abuts it. Additionally, the actuating lever acts upon a measuring device which is constructed as an arrangement of a Hall sensor and a permanent magnet. However, self-adjustment is not possible with this set up.

US patent application publication 2004/0257068 A1 relates to a device for adjusting rotation angles, in particular to an electrical rotary switch. The device has a stator and a rotor which is mounted on the stator such that it can rotate, such that the rotor can be moved between at least two rotation angle positions. Furthermore, the device has a magnet, in particular a permanent magnet, which can be moved by means of the rotor, and a magnetic field sensor, in particular a Hall sensor, which is associated with the magnet, in order to produce a signal which corresponds to the rotation angle position. The stator has a receptacle which is open on one side and is in particular approximately in the form of a pot, with the receptacle forming a rotating bearing for the rotor. The magnetic field sensor is arranged in the receptacle on the stator and/or on a part which is mounted in the stator, such that the stator is used as a mount for the magnetic field sensor. The magnet can be arranged such that it can be moved in order to adjust its position with respect to the rotor, so as to allow adjustment of the position of the magnet in one rotation angle position of the rotor.

The published German patent application DE 4303403 A1 discloses a linear displacement position detector that has a sensor element which possesses a ferromagnetic magnetoresistive surface of predetermined pattern formed by a comb-shaped matrix of e.g. nickel-iron encapsulated in synthetic resin and mounted on a ceramic circuit board in an electromagnetically screened chamber. A rectangular bar magnet with end poles is attached to a slider and an operating stem, and moves against the compression spring so that its flux interacts with the matrix. The resultant change in output voltage from the sensor at the terminal is amplified and displayed as a measure of stem movement.

WO 01/29515 A1 relates to a user input device that receives a user input on a power machine. The user input device includes a housing and a Hall Effect sensor disposed on the housing. A magnetic element is movably disposed relative to the Hall Effect sensor. A handle, lever or foot pedal is operably coupled to the magnetic element such that operator actuation of the operator actuable input device causes movement of the magnetic element relative to the Hall Effect sensor. The Hall Effect sensor provides an output signal indicative of such movement, and of the position of the magnet with respect to the Hall element.

US patent 6,472,624 B1 relates to a flow switch with a sensor and an actuator magnet, wherein the magnet is mounted on the plunger in order activate the sensor which is operable to detect the missing control from the magnet in case that no water is flowing.

The object of the present invention is to improve a non-contact position sensor of the type mentioned in the introduction to that effect that it permits smooth self-adjustment which if necessary can also be returned reversibly to the starting state and nevertheless is simple and economical to manufacture. Furthermore, the object of the present invention is to provide a process for the adjustment of a non-contact position sensor of this type.

This object is achieved by the subject matter of the independent claims. The sub-claims relate to advantageous developments of the present invention.

The present invention is based on the idea of providing an assembly apparatus for the indicator element which holds the indicator element in a pre-assembled position in a defined location relative to the detector unit while at the same time the actuating unit may be moved along the actuating axis relative to the indicator element and the assembly apparatus is to be constructed so that it is substantially tubular and is rotatable about the actuating axis for movement between the pre-assembled and final assembled position. This rotatable construction enables the position sensor to be arranged compactly even in the pre-assembled position, for example on a pedal block, and enables the final adjustment to be carried out in a very simple manner. In particular, the electrical signal from the sensor need not be used for adjustment of the indicator element, and this considerably simplifies assembly. In addition this type of mechanical self-adjustment also guarantees good switching accuracy. The rotatable construction has the additional advantage that during automated assembly no additional parts need be introduced.

In accordance with an advantageous embodiment of the present invention, the actuating unit is formed by a plunger at least in part with an elongate external diameter. This plunger is accommodated at least in part by the assembly apparatus and the assembly apparatus has an elongate internal diameter which corresponds to the external diameter of the plunger and of which the dimensions are chosen so the plunger may be moved in the pre-assembled position and the assembly apparatus is fixed by clamping to the plunger in the final assembled position. In this manner, a secure fixing of the indicator element onto the actuating unit can be achieved which guarantees a secure fix even under the strong thermal and mechanical loads in a vehicle. Furthermore, a force-fit of this type of the assembly apparatus with the indicator element on the actuating unit permits a smooth and therefore extremely exact adjustment of the indicator element on the actuating unit. Finally, such a force-fit makes it possible to release the connection between the assembly apparatus and the actuating unit as often as desired, if necessary.

The need to reversibly detach the indicator element from the actuating unit again can arise during the manufacture of a vehicle if, for example, after the complete installation of the pedal block it is ascertained that the switching point of the brake pedal is no longer optimally adjusted. But also during the operation of the vehicle, it may be necessary in the event of a repair to carry out a re-adjustment of the brake light switch.

The force fit between the plunger and the assembly apparatus may be achieved in the simplest manner if the external diameter of the plunger and/or the internal diameter of the assembly apparatus have an elliptical form. In this manner, in cases where both diameters have the form of an ellipse with, in each case a long and a short axis, the axes are so selected, that in the case of a concentric arrangement in which at any one time the short axis and the long axis do not form an angle with each other, sufficient play is available for the plunger to move through the assembly apparatus and, on the other hand, in the case of a rotation of both elliptical diameters counter to each other for the longer axis of the plunger to be at least as long as the short axis of the internal diameter of the assembly apparatus.

Obviously other elongate forms can also be used in arbitrary combinations - as long as only in the pre-assembled position sufficient play and in the final assembled position rotated opposite to the pre-assembled position the force-fitting of the assembly apparatus on the plunger is assured.

According to an advantageous development of the present invention, the assembly apparatus has a carrier in which the indicator element is held and a separate mounting element in which the carrier is axially displaceably guided and is fixed in a radial direction. In this manner the installation of the indicator element and the manufacture of the assembly apparatus may easily be carried out as such.

If a housing for the position sensor according to the present invention is provided, in which the detector unit is fitted and which at least partially surrounds the assembly apparatus, then the exactly defined position between the indicator element and the sensor may be determined in a simple manner by the fitting of the assembly apparatus to the housing. Moreover protection against external influences improves the long term stability of the arrangement.

A particularly exact adjustment can thus be achieved by arranging in such a housing a radially extending guide groove that, in conjunction with at least a guide protrusion formed on the assembly apparatus, fixes the assembly apparatus in the direction of the actuating axis relative to the detector unit in such a manner as to make it rotatable about the actuating axis.

According to an advantageous development in addition there is arranged on the housing an engagement device for locking the position sensor with a brake pedal. In this manner the whole position sensor unit can be pre-mounted on a pedal block and need not be supplied as a separate part or arranged in a footwell panel in a complex assembly operation.

Moreover in order to avoid an unintentional release of the position sensor from the brake pedal in the final assembled position, a locking device can be provided for locking the engagement device on the assembly apparatus, which is so constructed that the locking is activated by rotating the assembly apparatus into the final assembled position.

The assembly apparatus advantageously has at least an actuating face which is accessible from the exterior and permits the operator to carry out the actuating procedure in a simple manner.

In order to ensure that the actuating element always remains in contact with the unit of which the position is to be ascertained, a return spring can also be provided for rerotation the actuating element. This can be, for example, a spiral spring which is supported on the housing of the position sensor and engages in a cavity in the plunger.

According to an advantageous embodiment of the present invention, the sensor is a Hall sensor and the indicator element is a permanent magnet. As well as the usual advantages of a non-contact measurement device like freedom from wear, the use of a Hall sensor in cooperation with at least a permanent magnet additionally offers the advantage of high measurement accuracy and reliable sensing, which is corrosion-free and substantially free of other undesirable influences, of the position of the indicator element. A Hall sensor reacts very sensitively to changes in the magnetic flux so that even small movements of the indicator element can be ascertained. The characteristics of a Hall sensor, i.e. the dependence of the sensor signal on the position of the indicator element and therefore the position of the actuating unit can be simply adapted by adaptation of the electrical circuitry for the Hall sensor or programming of the evaluation electronics to the given wishes and requirements. The permanent magnet which moves with the actuating unit serves in this manner as the indicator element and a Hall sensor fitted stationarily in a housing of the detector unit is influenced in its environment by the change in the magnetic flux and therefore changes its output signal.

Alternatively to this arrangement, however, an inductive proximity sensor (eddy current sensor) which is influenced by the proximity of a metallic plate can also be used as a sensor. Finally, systems are also conceivable which work on a capacitive or optical basis.

The advantageous properties of the non-contact position sensor according to the invention become apparent in particular if the actuating unit is connectable to a brake pedal and the sensor signal is so designed that it switches a brake light as a function of a position of the brake pedal. Certainly the principles according to the invention may also be transferred to other proximity switch systems and also to systems in which the sensor signal supplies information about the exact position of the indicator element. Furthermore, more than one sensor and more than one indicator element can obviously be provided in the non-contact position sensor according to the invention.

A substantial advantage of the non-contact position sensor according to the invention is that a method for adjusting this position sensor, apart from the steps of the actual adjustment, also makes it possible to move the indicator element back into the original pre-assembled position again and in this manner to be able to repeat this step of the adjustment as often as required. For this purpose, according to the invention, the actuating unit is moved into an unlocked position and the assembly apparatus is rotated in order to move the indicator element into a partially unlocked position in which it is movable in the direction of the actuating axis only as far as the pre-assembled position but is still fixed to the actuating unit. Subsequently the actuating unit is moved into the zero-position called the defined position and the assembly apparatus is rotated in order to move the indicator element back into the original pre-assembled position which can also be called the basic state. In doing this the connection between the assembly apparatus and the actuating unit is released again. This is made possible in an advantageous manner by fixing the assembly apparatus by a force fit to the actuating unit which, by a counter rotation of the assembly apparatus can be released again by using sufficient force.

The invention is described in more detail hereinafter by means of the embodiments illustrated in the enclosed drawings. Similar or corresponding details are given the same reference numerals in the figures, in which
Fig. 1 is a perspective exploded view of a position sensor according to the invention in a pre-assembled position;
Fig. 2 is a perspective exterior view of the arrangement from Fig. 1 in the pre-assembled position.
Fig. 3 is a partially opened perspective view of the position sensor from Fig. 2
Fig. 4 is a section through the arrangement from Fig. 3 along the section line 4-4;
Fig. 5 is a detail from Fig. 4;
Fig. 6 is a perspective partially sectional view of the non-contact position sensor according to the invention in a final assembled position;
Fig. 7 is a cross section through the arrangement from Fig. 6 along the section line 7-7;
Fig. 8 is a detail from Fig. 7;
Fig. 9 is a partially opened perspective view of the non-contact position sensor in a position which results if the brake pedal is actuated.
Fig. 10 is a partially opened perspective view of the arrangement from Fig. 9 before an unlocking step;
Fig. 11 is a section through the arrangement from Fig. 10 along the section line 11-11;
Fig. 12 is a partially opened perspective view of the non-contact position sensor in the re-unlocked setting.

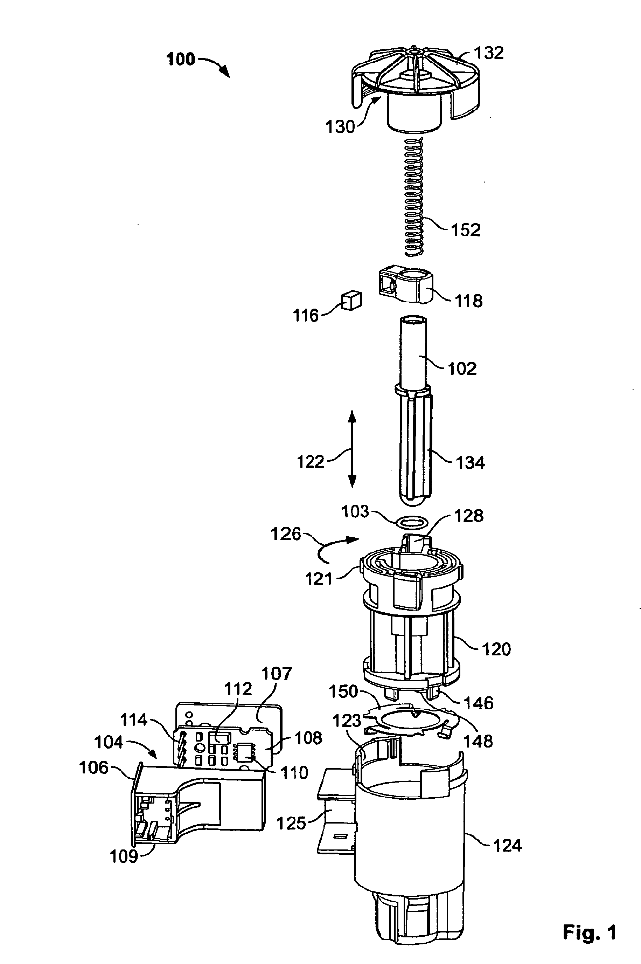

Fig. 1 shows a brake light switch for a brake pedal in a pre-assembled position in a perspective view as an example of a non-contact position sensor 100 according to the present invention.

On account of its basic physical principle, the position sensor 100, in the following also called proximity switch or brake light switch, comprises an actuating unit 102, which according to the European patent EP 0751 541 B1 is connected to a brake pedal (not shown), and a detector unit 104 which upon reaching a specific position of the actuating unit 102 closes an electrical circuit (not shown) with a brake light. In this embodiment, the detector unit 104 includes a detector housing 106 in which is fitted a circuit carrier 108, which carries a Hall sensor as a sensor 110. Furthermore, various components 112 necessary for signal evaluation as well as terminals 114 needed for further transmission of the switching signal are arranged on the circuit carrier 108, shown as a printed circuit board (PCB) herein.

In the specific embodiment shown here, the geometrical position of the actuating unit 102, which is connected to the brake pedal (not shown) is detected by means of the sensor 110, which measures the magnetic field of an indicator element 116 fitted to the actuating unit 102 in a final assembled position. According to the invention, a permanent magnet functions as the indicator element 116 and is supported in a pre-assembled position in an assembly apparatus formed by a carrier 118 and a mounting element 120.

As will be explained in detail with reference to the following figures, the indicator element 116 held on the carrier 118 is positioned in Fig. 1 in the pre-assembled position in which the actuating unit 102 in the form of a plunger, is still freely movable in an actuating direction 122. The assembly apparatus formed by the carrier 118 and the mounting element 120 is held in a housing 124 in such a manner that the indicator element 116 takes up an exactly specified geometrical position in the actuating direction 122 relative to the detector unit 104 also mounted on the housing 124. In the embodiment shown, this defined position corresponds to the position which the indicator element 116 should have in subsequent operation when the actuating unit 102 is in the rest position, i.e. when the brake pedal (not shown) is not actuated.

By a rotational movement in direction 126, which is carried out by an operator with the aid of actuating faces 128, the indicator element 116, which is held in the carrier 118, can be moved during assembly along a radially peripheral face into a final assembled position in which it is fixed on the actuating unit 102 and can be moved in response to movement of the brake pedal (not shown) in the actuating direction 122.

The actuating faces 128 are accessible from the outside through corresponding openings 130 in a lid 132, which closes the housing 124.

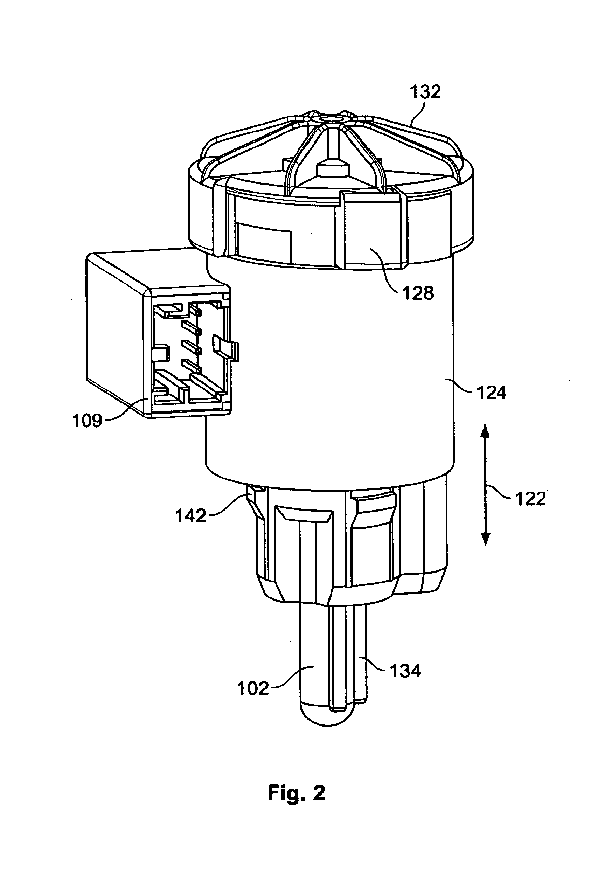

The non-contact position sensor 100 according to the invention in its pre-assembled position will now be described in detail with additional reference to Figs. 2 to 5, all of which relate to the pre-assembled position shown in Fig. 1. In this embodiment, the actuating unit 102 is located in a position which corresponds to a zero position of the brake pedal (not shown) connected to the actuating unit 102. The actuating unit 102 possesses guide protrusions 134, which cooperate with associated grooves in the housing 124 so that the actuating unit 102 may be moved in the actuating direction 122 relative to the housing 124 but cannot be rotated.

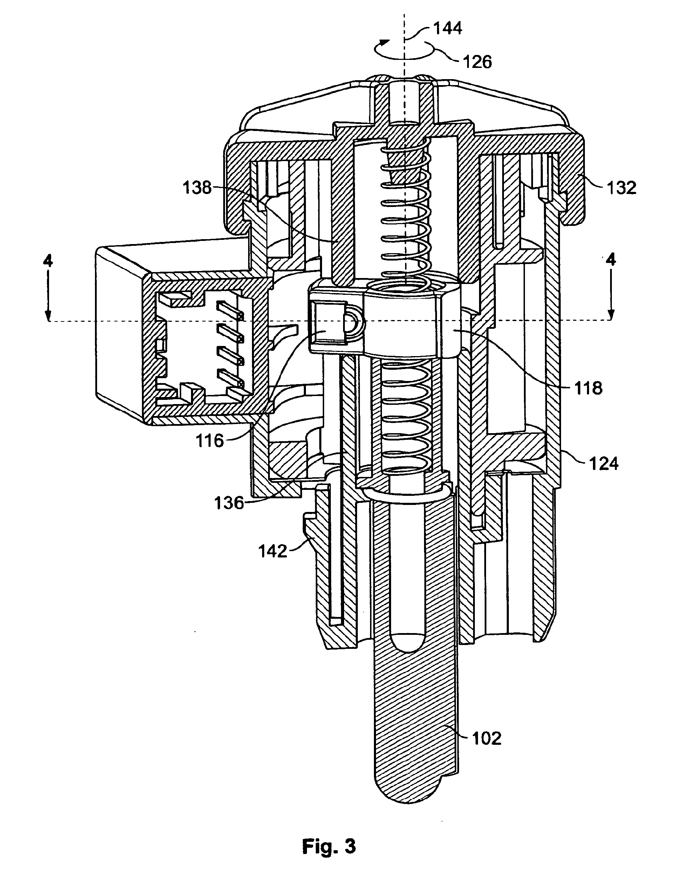

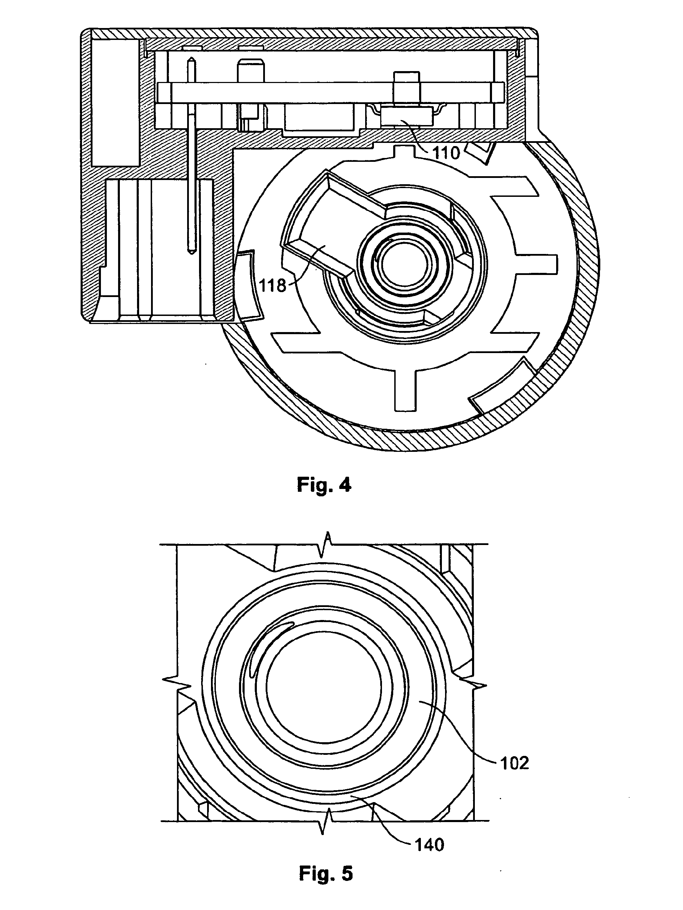

In the partially opened view of Fig. 3 it is clear that the indicator element 116, which is held in the carrier 118 is exactly positioned in the pre-assembled position between a first stop 136 on the housing 124 and a second stop 138 provided on the lid 132 in an axial direction relative to the detector unit 104 and the sensor 110 contained in it. In this position, the actuating unit 102 is freely movable in the actuating direction 122 relative to the carrier 118. This is achieved in that, as can be seen in Figs. 4 and 5, the external diameter of the actuating unit 102 on the one hand and the internal diameter of the carrier 118 on the other are both elliptically constructed so that in the pre-assembled position the longitudinal axis of these ellipses are congruent, i.e. do not make an angle to one another, and therefore sufficient play is available in a region 140 (Fig. 5) for the movability of the actuating unit 102.

For latching the non-contact position sensor 100 with the brake pedal (not shown), the housing 124 possesses a total of three catch-hooks 142. The catch hooks 142 are equally distributed about the circumference of the housing 124. But obviously many other forms of locking with the brake pedal (not shown) could also be provided.

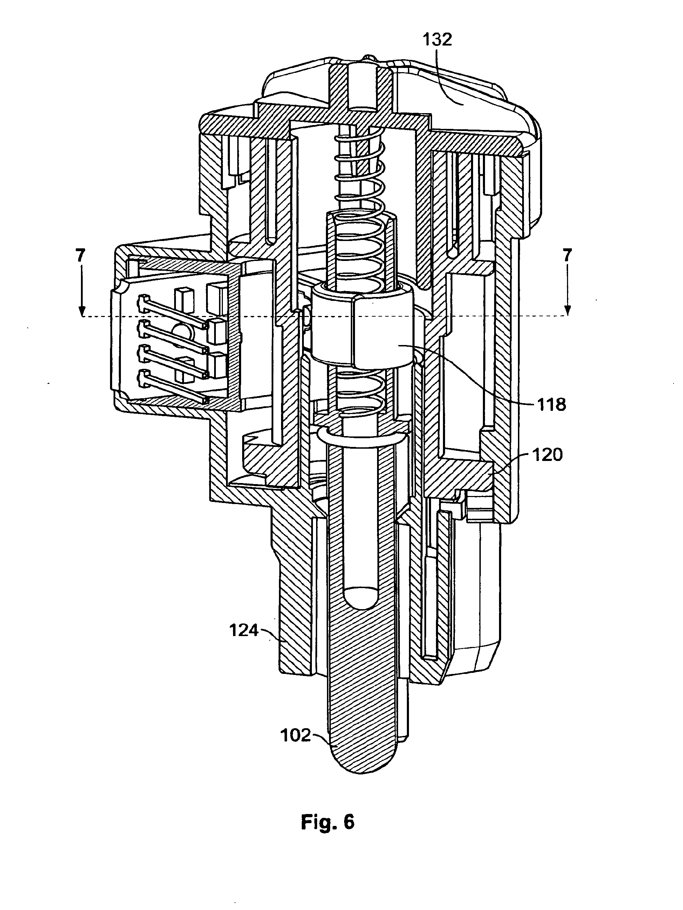

The passage to the final assembled position will be explained with reference to Figs. 6 to 8. In these embodiments the self-adjustment passage from the pre-assembled position shown in Fig. 3 into the final assembled position is effected by a rotation of the mounting element 120, called a rotator for this reason, in a direction 126, i.e. about an actuating axis 144 (Fig. 3) defined by the actuating unit 102.

In this embodiment, the carrier 118 is held in such a way during this rotation that its position in the longitudinal direction relative to the actuating unit 102 on the one hand and relative to the sensor 110 on the other does not change at all. Because the actuating unit 102 is gripped with the aid of the guide protrusions 134 on the housing 124, therefore unable to rotate any more, the elliptical external diameter of the carrier 118 rotates due to the rotational movement in such a manner that the longitudinal axes of both of the elliptical diameters enclose an angle.

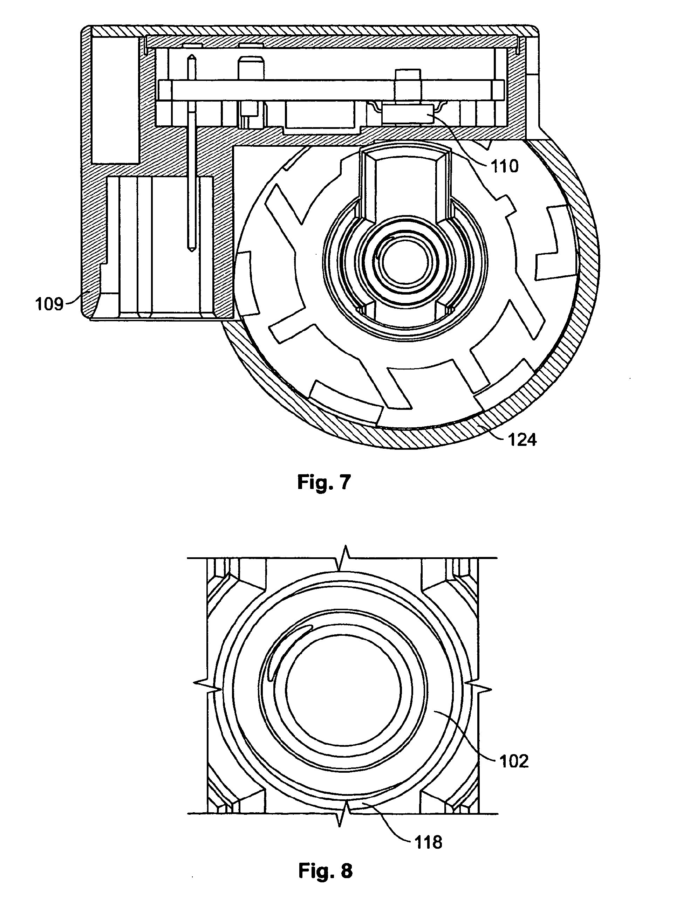

If suitable geometrical dimensions are selected then, as depicted in Fig. 8, a force fit of the actuating unit elliptical external diameter occurs within the also elliptical carrier internal diameter. With that, the indicator element 116 retained within the carrier 118 is firmly fixed on the actuating unit 102 and simultaneously also automatically adjusted relative to the sensor 110 in the optimum manner. Moreover, because of the rotational movement, the indicator element 116 is moved out from the first and second stops 136, 138 and is located in a guide groove in which it is movable in the actuating direction 122 moved by the actuating unit 102. The position of the actuating unit 102 shown in Fig. 6 corresponds to a position in which the brake pedal (not shown) is not actuated, therefore to the zero-point of the whole arrangement.

As can be seen from the general view of Fig. 1, three catch hook securing means 146 additionally grip behind the catch hooks 142 in this position and so advantageously prevent an unintentional release of the position sensor 100 from the brake pedal (not shown). A compensation spring 150 tensioned by cams 148 additionally ensures that no more play occurs between a pedal socket (not shown) and the non-contact position sensor 100 in this final assembled position.

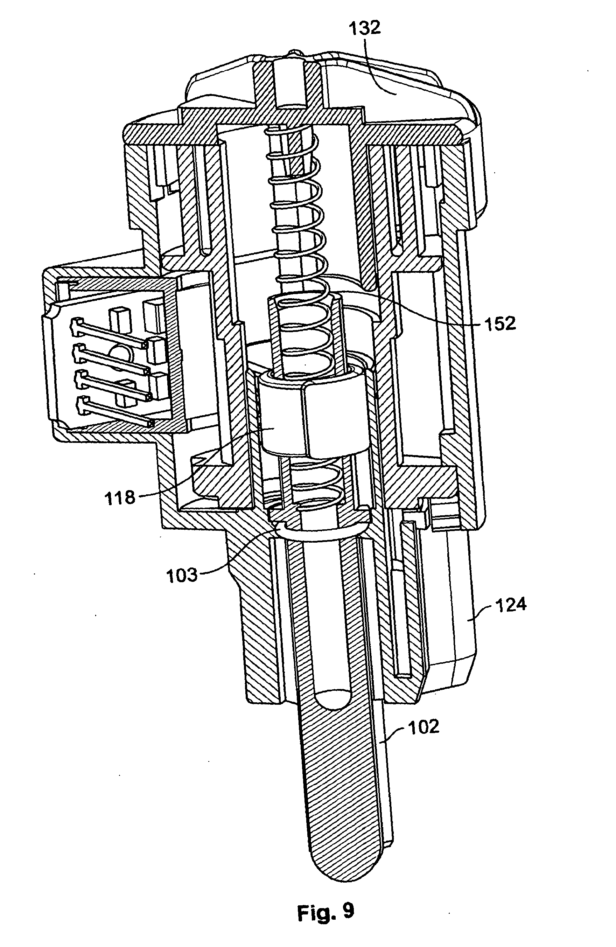

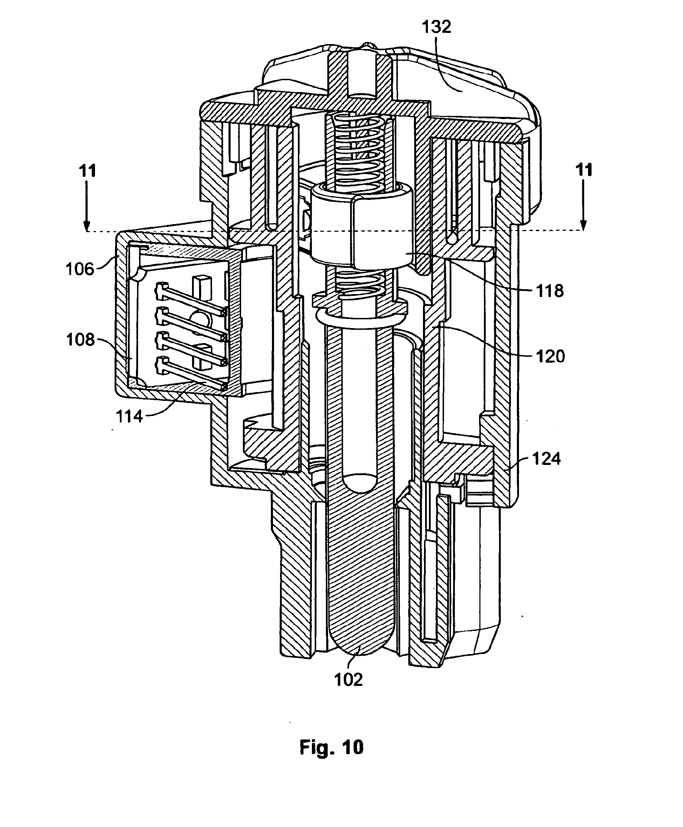

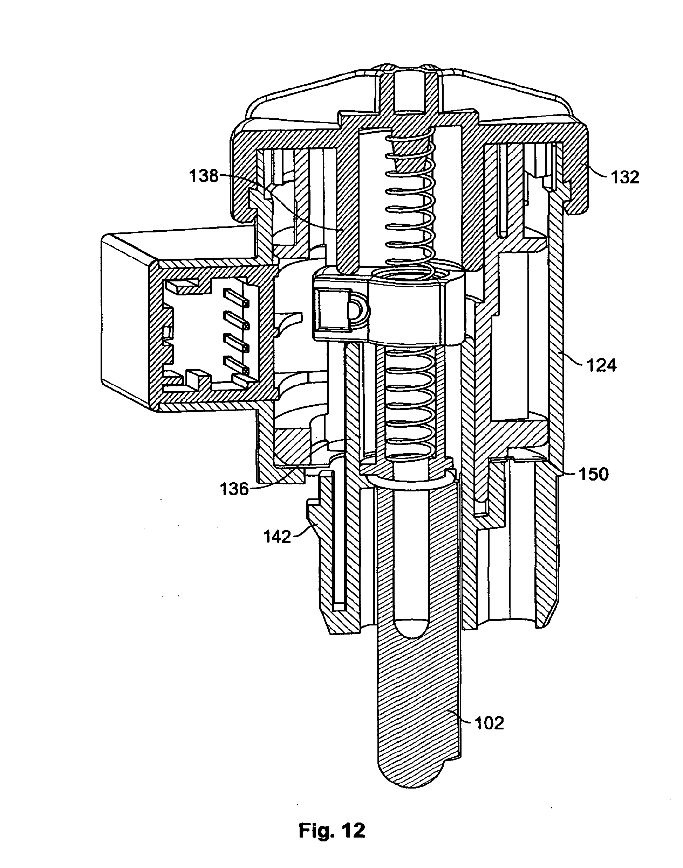

Unlocking of these two components from each other and a complete return of the arrangement to the pre-assembled position can be achieved particularly simply due to the force-fit attachment of the carrier 118 to the actuating unit 102. This procedure will be described in detail with reference to Figs. 9 to 12.

Fig. 9 shows the situation when the brake pedal (not shown) is actuated and as a result the actuating unit 102 is moved downwards due to the effect of a return spring 152. In this embodiment, the carrier 118 will be guided with the indicator element 116 in a corresponding guide groove on the housing 124. This corresponds to normal operation.

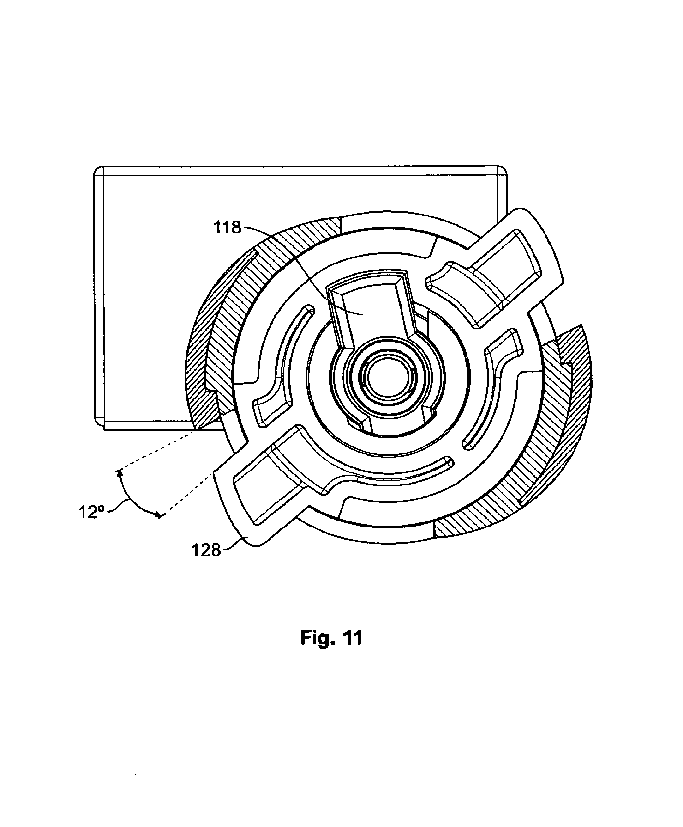

If, however, a new adjustment of the arrangement is found to be necessary, this can be effected according to the invention if the brake pedal (not shown) is completely drawn back so that the actuating unit 102 is therefore pressed into the position sensor arrangement up to the lid 132. Together with the actuating unit 102, the carrier 118 is also moved into a corresponding guide groove in the lid 132. According to the invention this guide groove is wider than the corresponding guide groove in the housing 124 so that in this unlocking position of the actuating unit 102 the mounting element 120 can be turned back by approximately 12 degrees, as indicated in Fig. 11.

If the brake pedal (not shown) is now unloaded and the actuating unit 102 moves back out of the lid 132 under the spring force of the return spring 152, then the carrier 118, upon entering into the housing 124, meets the first stop 136. If in this position the mounting element 120 is rotated back into the pre-assembled position, the force-fit between the carrier 118 and the actuating unit 102 is released and simultaneously the carrier 118 is held again in its pre-assembled position between the first stop 136 and the second stop 138. The adjustment process can be recommenced from this starting position. If necessary, the procedure can be carried out as often as desired.

The individual steps of fitting, adjustment and unlocking will be described in detail in succession in an overview with reference to Figs. 1 to 12. The assembly of the position sensor 100 according to the invention begins with the assembly of the detector unit 104 in which the circuit carrier 108 is fitted with the sensor 110 into the detector housing 106 and is closed with a cover 107. A collar 109, which is formed on the detector housing 106, makes the connection to the terminals 114 possible.

Subsequently, the detector unit 104 is fitted in a corresponding socket 125 on the housing 124. In a next assembly step, the compensation spring 150 is inserted and the mounting element 120 is mounted on the compensation spring 150. A seal or O-ring 103 preferably of a resilient plastics material is fixed on the actuating unit 102 and should muffle possible actuating unit noises due to the first and second stops 136, 138.

The actuating unit 102 is positioned in the housing 124 so that the protrusions 134 fit into the corresponding guide groove on the housing 124. The indicator element 116 is warm-caulked in the carrier 118 and the carrier 118 is then fitted in the corresponding socket on the mounting element 120. In this position, the carrier 118 rests on the first stop 136 of the housing 124.

The return spring 152 is now fitted over the corresponding positioning mandrel on the lid 132 and the lid 132 is placed over the arrangement. The lid 132 engages in the housing 124. The actuating faces 128 remain accessible from the exterior similarly the collar 109 and the actuating unit 102 which comes into contact with the brake pedal (not shown).

Now the whole unit in the pre-assembled position can be locked on the pedal socket (not shown) with the aid of the catch hooks 142. In this position, the whole pedal block can be stored and be supplied whereas the actual adjustment is only carried out on the vehicle.

For the adjustment, the brake pedal (now shown) is brought into a zero status and the actuating unit 102 takes up the corresponding defined zero position. Now by rotation the mounting element 120 and the carrier 118 held between the first and second stops 136, 138 is rotated in such a way that on the one hand it is force-fitted onto the actuating unit 102 and on the other hand is arranged in the region of the guide groove in which it is freely movable in a direction parallel to the actuating direction 122 of the actuating unit 102. This is the normal actuating state of the adjusted position sensor 100. During this rotational movement, the mounting element 120 is thereby being guided with its guide protrusions 121 in radial guide grooves 123 provided on the housing 124 and is held in an axial direction.

In the case that a new adjustment of the arrangement is necessary, a complete return to the basic state can also be achieved with the non-contact position sensor 100 according to the invention, i.e. the pre-assembled position. For this purpose, the brake pedal (now shown) is moved into a withdrawn position so that the actuating unit 102 moves into the lid 132. Because the guidance of the carrier 118 is wider in the lid 132 than in the corresponding housing 124, in this position, the mounting element 120 can be turned back by approximately 12 degrees again in the direction of the pre-assembled position. At the same time, the side wall of the guide groove in the lid 132 forms a stop for this rotational movement.

If the actuating unit 102 is now unloaded, it again moves itself away from the lid 132 under the influence of the return spring 152 and the carrier 118, which is still fixed to the actuating unit 102 follows this movement until it hits the first stop 136. The mounting element 120 can now be turned back completely into the pre-assembled position and by application of suitable force the force-fit between the carrier 118 and the actuating unit 102 will be released again so that the position sensor 100 is again in the pre-assembled position. Also the catch hooks 142 are freed from the catch hook securing means 146 so that in the event of damage the position sensor 100 can also be removed without difficulty and exchanged or repaired.

Following the principles according to the invention, a non-contact position sensor 100 can be created which allows a simple smooth adjustment of a brake light switch in order to compensate for the brake pedal tolerances and at the same time can be supplied pre-assembled on the brake pedal (not shown). Furthermore, the arrangement may be set back to the basic state as often as desired and made accessible for a renewed adjustment.

The characteristics of the present invention described hereinbefore and in the claims can be achieved both individually as well as in various combinations. Therefore the invention is not limited to the embodiments described but may be modified within the scope defined by the claims. Thus by way of an example, the force-fit between the actuating unit 102 and the carrier 118 can be produced using arbitrary longitudinally formed and correspondingly matched cross-sectional forms.

## Claims

1. Non-contact position sensor with a detector unit (104) which has a sensor (110) for producing a sensor signal in response to a geometrical position of an indicator element (116) relative to the sensor (110),
wherein the indicator element (116) is mounted on an actuating unit (102) by means of an assembly apparatus (118, 120) in a final assembled position, so that its geometrical position can be changed by the actuating unit (102), and wherein the assembly apparatus (118, 120) has a substantially tubular form and is rotatable about an actuating axis (144) for movement between a pre-assembled and final assembled position,
said position sensor further comprising a housing (124) in which the detector unit (104) is mounted and which at least partially surrounds the assembly apparatus (118, 120),
wherein said housing (124) has
a first and second stop (136, 138) for holding, in the pre-assembled position, the indicator element (116) in a defined position relative to the detector unit (104) while the actuating unit (102) is movable along said actuating axis (144) relative to the indicator element (116), and
a longitudinal guide groove in which the indicator element (116) is movable in the actuating direction (122) moved by the actuating unit (102) in the final assembled position,
wherein at least a radially extending guide groove (123) is arranged on the housing (104) and, in cooperation with at least a guide protrusion (121) formed on the assembly apparatus (118, 120), fixes the assembly apparatus in the direction of the actuating axis relative to the detector unit in such a way as to make it rotatable about the actuating axis.

2. Non-contact position sensor according to claim 1, wherein the actuating unit (102) is formed by a plunger with an external diameter which is at least in part elongate, the plunger being accommodated at least in part by the assembly apparatus (118, 120) and wherein the assembly apparatus has an elongate internal diameter which corresponds to the plunger external diameter, and of which the dimensions are selected in such a way that the plunger is movable in the pre-assembled position and the assembly apparatus is fixed by force-fit on the plunger in the final assembled position.

3. Non-contact position sensor according to claim 2, wherein the plunger external diameter and/or the internal diameter of the assembly apparatus have an elliptical form.

4. Non-contact position sensor according to at least one of the preceding claims wherein the assembly apparatus is formed by a carrier (118), in which the indicator element (116) is contained, and an mounting element (120), in which the carrier is axially movably guided and fixed in a radial direction.

5. Non-contact position sensor according to one of the preceding claims, wherein an engagement device (142) is arranged on the housing (124) for locking the position sensor with a brake pedal.

6. Non-contact position sensor according to claim 5 wherein a securing means (146) is arranged on the assembly apparatus for locking the engagement device (142) in the final assembled position.

7. Non-contact position sensor according to at least one of the preceding claims, wherein at least an actuating face (128) accessible from outside is formed on the assembly apparatus (118, 120).

8. Non-contact position sensor according to at least one of the preceding claims, which also includes a return spring (152) for re-setting the actuating unit (102).

9. Non-contact position sensor according to at least one of the preceding claims, wherein the sensor (110) has at least a Hall sensor and the indicator element (116) comprises at least a permanent magnet.

10. Method for adjusting a non-contact position sensor with a detector unit which has a sensor for producing a sensor signal in response to a geometrical position of an indicator element relative to the sensor, wherein the method has the following steps:
fixing of the indicator element held in an assembly apparatus in a pre-assembled position relative to the detector unit,
positioning of an actuating unit along an actuating axis in a defined position relative to the detector unit,
moving of the indicator element into a final assembled position in which it is fixed to the actuating unit in such a way that, in order to produce the sensor signal, its geometrical position relative to the detector unit can be changed by the actuating unit,
wherein the assembly apparatus has a substantially tubular form and is rotated about the actuating axis to move the indicator element between the pre-assembled and final assembled position,
wherein the non-contact position sensor also has a housing, in which the detector unit is mounted and which at least partially surrounds the assembly apparatus, and
wherein a radially extending guide groove is arranged on the housing and, in conjunction with the guide protrusions formed on the assembly apparatus, fixes the assembly apparatus in the direction of the actuating axis relative to the detector unit in such a manner that it is rotatable about the actuating axis.

11. Method according to claim 10, wherein the actuating unit is formed by a plunger with an external diameter which is at least in part elongate, the plunger being accommodated at least in part by the assembly apparatus and wherein the assembly apparatus has an elongate internal diameter which corresponds to the plunger external diameter, and of which the dimensions are selected in such a way that the plunger is movable in the pre-assembled position and the assembly apparatus is fixed by force-fit on the plunger in the final assembled position.

12. Method according to claim 11 wherein the plunger external diameter and/or the internal diameter of the assembly apparatus have an elliptical form.

13. Method according to at least one of claims 10 to 12, wherein the assembly apparatus is formed by a carrier, in which the indicator element is held, and a mounting element, in which the carrier is axially movably guided and fixed in a radial direction.

14. Method according to any one of claims 10 to 13, also including the steps:
moving of the actuating unit into the unlocking position,
rotation of the assembly apparatus in order to move the indicator element into a partially unlocked position, in which it is movable in the direction of the actuating axis, only as far as the pre-assembled position,
moving of the actuating unit into the defined position,
rotation of the assembly apparatus in order to move the indicator element back into the original pre-assembled position in which it is no longer fixed to the actuating unit.

15. Method according to any one of claims 10 to 14, wherein the defined position of the actuating unit corresponds to the non-actuated position of a brake pedal connected to the actuating unit.

16. Method according to at least one of claims 10 to 15, wherein the sensor has at least a Hall sensor and the indicator element comprises at least a permanent magnet.

## Patentansprüche

1. Kontaktloser Positionssensor mit einer Detektoreinheit (104), die einen Sensor (110) hat, um als Reaktion auf eine geometrische Position eines Indikatorelements (116) im Verhältnis zu dem Sensor (110) ein Sensorsignal zu erzeugen,
wobei das Indikatorelement (116) in einer endgültigen montierten Position mit Hilfe einer Montagevorrichtung (118, 120) an einer Betätigungseinheit (102) befestigt ist, so dass seine geometrische Position in der Betätigungseinheit (102) verändert werden kann, und wobei die Montagevorrichtung (118, 120) eine im Wesentlichen röhrenförmige Gestalt hat und für eine Bewegung zwischen einer vormontierten und einer endgültigen montierten Position um eine Betätigungsachse (144) gedreht werden kann,
wobei der Positionssensor ferner ein Gehäuse (124) umfasst, in der die Detektoreinheit (104) angebracht ist und das wenigstens teilweise die Montagevorrichtung (118, 120) umschließt,
wobei das Gehäuse (124) Folgendes hat:
einen ersten und einen zweiten Anschlag (136, 138), um, in der vormontierten Position, das Indikatorelement (116) in einer definierten Position im Verhältnis zu der Detektoreinheit (104) zu halten, während die Betätigungseinheit (102) entlang der Betätigungsachse (144) im Verhältnis zu dem Indikatorelement (116) bewegt werden kann, und
eine Längsführungsrille, in der das Indikatorelement (116), bewegt durch die Betätigungseinheit (102) in der endgültigen montierten Position, in der Betätigungsrichtung (122) bewegt werden kann,
wobei wenigstens eine sich in Radialrichtung erstreckende Führungsrille (123) an dem Gehäuse (104) angeordnet ist und, in Zusammenwirken mit wenigstens einem an der Montagevorrichtung (118, 120) geformten Führungsvorsprung (121), die Montagevorrichtung in der Richtung der Betätigungsachse im Verhältnis zu der Detektoreinheit auf eine solche Weise fixiert, dass sie um die Betätigungsachse drehbar gemacht wird.

2. Kontaktloser Positionssensor nach Anspruch 1, wobei die Betätigungseinheit (102) durch einen Tauchkolben mit einem Außendurchmesser, der wenigstens zum Teil länglich ist, gebildet wird, wobei der Tauchkolben wenigstens zum Teil durch die Montagevorrichtung (118, 120) aufgenommen wird und wobei die Montagevorrichtung einen länglichen Innendurchmesser hat, der dem Tauchkolben-Außendurchmesser entspricht, und dessen Abmessungen auf eine solche Weise ausgewählt sind, dass der Tauchkolben in der vormontierten Position bewegt werden kann und die Montagevorrichtung in der endgültigen montierten Position durch Kraftschluss an dem Tauchkolben fixiert wird.

3. Kontaktloser Positionssensor nach Anspruch 2, wobei der Tauchkolben-Außendurchmesser und/oder der Innendurchmesser der Montagevorrichtung eine elliptische Form haben.

4. Kontaktloser Positionssensor nach wenigstens einem der vorhergehenden Ansprüche, wobei die Montagevorrichtung durch einen Träger (118), in dem das Indikatorelement (116) enthalten ist, und ein Anbringungselement (120), in dem der Träger in Axialrichtung beweglich geführt und in einer Radialrichtung fixiert wird, gebildet wird.

5. Kontaktloser Positionssensor nach einem der vorhergehenden Ansprüche, wobei eine Eingriffsvorrichtung (142) an dem Gehäuse (124) angeordnet ist, um den Positionssensor mit einem Bremspedal zu arretieren.

6. Kontaktloser Positionssensor nach Anspruch 5, wobei ein Befestigungsmittel (146) an der Montagevorrichtung angeordnet ist, um die Eingriffsvorrichtung (142) in der endgültigen montierten Position zu arretieren.

7. Kontaktloser Positionssensor nach wenigstens einem der vorhergehenden Ansprüche, wobei wenigstens eine von der Außenseite zugängliche Betätigungsfläche (128) an der Montagevorrichtung (118, 120) geformt ist.

8. Kontaktloser Positionssensor nach wenigstens einem der vorhergehenden Ansprüche, der ebenfalls eine Rückstellfeder (152) zum Zurücksetzen der Betätigungseinheit (102) einschließt.

9. Kontaktloser Positionssensor nach wenigstens einem der vorhergehenden Ansprüche, wobei der Sensor (110) wenigstens einen Hall-Sensor hat und das Indikatorelement (116) wenigstens einen Dauermagneten umfasst.

10. Verfahren zum Einstellen eines kontaktlosen Positionssensors mit einer Detektoreinheit, die einen Sensor hat, um als Reaktion auf eine geometrische Position eines Indikatorelements im Verhältnis zu dem Sensor ein Sensorsignal zu erzeugen, wobei das Verfahren die folgenden Schritte hat:
das Fixieren des in einer Montagevorrichtung gehaltenen Indikatorelements in einer vormontierten Position im Verhältnis zu der Detektoreinheit,
das Anordnen einer Betätigungseinheit entlang einer Betätigungsachse in einer definierten Position im Verhältnis zu der Detektoreinheit,
das Bewegen des Indikatorelements in eine endgültige montierte Position, in der es auf eine solche Weise an der Betätigungseinheit befestigt ist, dass, um das Sensorsignal zu erzeugen, ihre geometrische Position im Verhältnis zu der Detektoreinheit durch die Betätigungseinheit verändert werden kann,
wobei die Montagevorrichtung eine im Wesentlichen röhrenförmige Gestalt hat und um die Betätigungsachse gedreht wird, um das Indikatorelement zwischen der vormontierten und der endgültigen montierten Position zu bewegen,
wobei der kontaktlose Sensor ebenfalls ein Gehäuse hat, in dem die Detektoreinheit angebracht ist und das wenigstens teilweise die Montagevorrichtung umschließt, und
wobei eine sich in Radialrichtung erstreckende Führungsrille an dem Gehäuse angeordnet ist und, in Zusammenwirken mit den an der Montagevorrichtung geformten Führungsvorsprüngen, die Montagevorrichtung in der Richtung der Betätigungsachse im Verhältnis zu der Detektoreinheit auf eine solche Weise fixiert, dass sie um die Betätigungsachse drehbar ist.

11. Verfahren nach Anspruch 10, wobei die Betätigungseinheit durch einen Tauchkolben mit einem Außendurchmesser, der wenigstens zum Teil länglich ist, gebildet wird, wobei der Tauchkolben wenigstens zum Teil durch die Montagevorrichtung aufgenommen wird und wobei die Montagevorrichtung einen länglichen Innendurchmesser hat, der dem Tauchkolben-Außendurchmesser entspricht, und dessen Abmessungen auf eine solche Weise ausgewählt sind, dass der Tauchkolben in der vormontierten Position bewegt werden kann und die Montagevorrichtung in der endgültigen montierten Position durch Kraftschluss an dem Tauchkolben fixiert wird.

12. Verfahren nach Anspruch 11, wobei der Tauchkolben-Außendurchmesser und/oder der Innendurchmesser der Montagevorrichtung eine elliptische Form haben.

13. Verfahren nach einem der Ansprüche 10 bis 12, wobei die Montagevorrichtung durch einen Träger, in dem das Indikatorelement gehalten wird, und ein Anbringungselement, in dem der Träger in Axialrichtung beweglich geführt und in einer Radialrichtung fixiert wird, gebildet wird.

14. Verfahren nach einem der Ansprüche 10 bis 13, das ebenfalls die folgenden Schritte einschließt:
das Bewegen der Betätigungseinheit in die Entriegelungsposition,
das Drehen der Montagevorrichtung, um das Indikatorelement in eine teilweise entriegelte Position zu bewegen, in der es in der Richtung der Betätigungsachse bewegt werden kann, nur bis zu der vormontierten Position,
das Bewegen der Betätigungseinheit in die definierte Position,
das Drehen der Montagevorrichtung, um das Indikatorelement zurück in die ursprüngliche vormontierte Position zu bewegen, in der es nicht mehr an der Betätigungseinheit befestigt ist.

15. Verfahren nach einem der Ansprüche 10 bis 14, wobei die definierte Position der Betätigungseinheit der nicht betätigten Position eines mit der Betätigungseinheit verbundenen Bremspedals entspricht.

16. Verfahren nach wenigstens einem der Ansprüche 10 bis 15, wobei der Sensor wenigstens einen Hall-Sensor hat und das Indikatorelement wenigstens einen Dauermagneten umfasst.

## Revendications

1. Capteur de position sans contact avec une unité de détecteur (104), comportant un capteur (110) pour produire un signal de capteur en réponse à une position géométrique d'un élément indicateur (116) par rapport au capteur (110)
dans lequel l'élément indicateur (116) est monté sur une unité d'actionnement (102) par l'intermédiaire d'un dispositif d'assemblage (118, 120) dans une position assemblée finale, de sorte que sa position géométrique peut être changée par l'unité d'actionnement (12), et dans lequel le dispositif d'assemblage (118, 120) a une forme pratiquement tubulaire et peut tourner sur un axe d'actionnement (144) en vue d'un déplacement entre une position préassemblée et une position assemblée finale ;
ledit capteur de position comprenant en outre un boîtier (124), dans lequel l'unité de détecteur (104) est montée et qui entoure au moins en partie le dispositif d'assemblage (118, 120) ;
dans lequel ledit boîtier (124) comporte :
des premier et deuxième arrêts (136, 138) pour retenir, dans la position préassemblée, l'élément indicateur (116) dans une position définie par rapport à l'unité de détecteur (104) pendant que l'unité d'actionnement (102) peut être déplacée le long dudit axe d'actionnement (144) par rapport à l'élément indicateur (116) ; et
une rainure de guidage longitudinale, dans laquelle l'élément indicateur (116) peut être déplacé dans la direction d'actionnement (122) par l'intermédiaire de l'unité d'actionnement (102) dans la position assemblée finale ;
dans lequel au moins une rainure de guidage à extension radiale (123) est agencée sur le boîtier (104), fixant, en coopération avec au moins une saillie de guidage (121) formée sur le dispositif d'assemblage (118, 120), le dispositif d'assemblage dans la direction de l'axe d'actionnement par rapport à l'unité de détecteur, de sorte à permettre sa rotation sur l'axe d'actionnement.

2. Capteur de position sans contact selon la revendication 1, dans lequel l'unité d'actionnement (102) est formée par un piston ayant un diamètre extérieur au moins en partie allongé, le piston étant reçu au moins en partie par le dispositif d'assemblage (118, 120), et dans lequel le dispositif d'assemblage a un diamètre intérieur allongé, correspondant au diamètre extérieur du piston, ses dimensions étant sélectionnées de sorte que le piston peut être déplacé dans la position préassemblée, le dispositif d'assemblage étant fixé par ajustement serré sur le piston dans la position assemblée finale.

3. Capteur de position sans contact selon la revendication 2, dans lequel le diamètre extérieur du piston et/ou le diamètre intérieur du dispositif d'assemblage ont une forme elliptique.

4. Capteur de position sans contact selon au moins une des revendications précédentes, dans lequel le dispositif d'assemblage est formé par un support (118), contenant l'élément indicateur (116), et un élément de montage (120), dans lequel le support est guidé par déplacement axial et fixé dans une direction radiale.

5. Capteur de position sans contact selon l'une des revendications précédentes, dans lequel un dispositif d'engagement (142) est agencé dans le boîtier (124) pour verrouiller le capteur de position par une pédale de frein.

6. Capteur de position sans contact selon la revendication 5, dans lequel un moyen de fixation (146) est fixé sur le dispositif d'assemblage pour verrouiller le dispositif d'engagement (142) dans la position assemblée finale.

7. Capteur de position sans contact selon au moins une des revendications précédentes, dans lequel au moins une face d'actionnement (128) accessible de l'extérieur est formée sur le dispositif d'assemblage (118, 120).

8. Capteur de position sans contact selon au moins une des revendications précédentes, englobant en outre un ressort de rappel (152) pour réajuster l'unité d'actionnement (102).

9. Capteur de position sans contact selon au moins une des revendications précédentes, dans lequel le capteur (110) comporte au moins un capteur à effet Hall, l'élément indicateur (116) comprenant au moins un aimant permanent.

10. Procédé d'ajustement d'un capteur de position sans contact avec une unité de détecteur, comportant un capteur pour produire un signal de capteur en réponse à une position géométrique d'un élément indicateur par rapport au capteur, le procédé comportant les étapes ci-dessous :
fixation de l'élément indicateur retenu dans un dispositif d'assemblage dans la position préassemblée par rapport à l'unité de détecteur ;
positionnement d'une unité d'actionnement le long d'un axe d'actionnement dans une position définie par rapport à l'unité de détecteur ;
déplacement de l'élément indicateur dans une position assemblée finale, dans laquelle il est fixé sur l'unité d'actionnement de sorte que, en vue de produire le signal de capteur, sa position géométrique par rapport à l'unité de détecteur peut être changée par l'unité d'actionnement ;
dans lequel le dispositif d'assemblage a une forme pratiquement tubulaire et est tourné sur l'axe d'actionnement pour déplacer l'élément indicateur entre la position préassemblée et la position assemblée finale ;
dans lequel le capteur de position sans contact comporte en outre un boitier, dans lequel l'unité de détecteur est montée et qui entoure au moins en partie le dispositif d'assemblage ; et
dans lequel une rainure de guidage à extension radiale est agencée sur le boîtier, fixant, en coopération avec la saillie de guidage formée sur le dispositif d'assemblage, le dispositif d'assemblage dans la direction de l'axe d'actionnement par rapport à l'unité de détecteur, de sorte à permettre sa rotation sur l'axe d'actionnement.

11. Procédé selon la revendication 10, fans lequel l'unité d'actionnement est formée par un piston ayant un diamètre extérieur au moins en partie allongé, le piston étant reçu au moins en partie par le dispositif d'assemblage, le dispositif d'assemblage ayant un diamètre intérieur allongé, correspondant au diamètre extérieur du piston, et dont les dimensions sont sélectionnées de sorte que le piston peut être déplacé dans la position préassemblée, le dispositif d'assemblage étant fixé par ajustement serré sur le piston dans la position assemblée finale.

12. Procédé selon la revendication 11, dans lequel le diamètre extérieur du piston et/ou le diamètre intérieur du dispositif d'assemblage ont une forme elliptique.

13. Procédé selon au moins une des revendications 10 à 12, dans lequel le dispositif d'assemblage est formé par un support, dans lequel est retenu un élément indicateur, et un élément de montage, dans lequel le support peut être guidé par déplacement axial et fixé dans une direction radiale.

14. Procédé selon l'une quelconque des revendications 10 à 13, englobant en outre les étapes ci-dessous
montage de l'unité d'actionnement dans la position de déverrouillage ;
rotation du dispositif d'assemblage en vue de déplacer l'élément indicateur dans une position en partie déverrouillée, dans laquelle il peut être déplacé dans la direction de l'axe d'actionnement, uniquement jusqu'à la position préassemblée ;
déplacement de l'unité d'actionnement dans la position définie ;
rotation du dispositif d'assemblage en vue de ramener l'élément indicateur dans la position préassemblée d'origine, dans laquelle il n'est plus fixé sur l'unité d'actionnement.

15. Procédé selon l'une quelconque des revendications 10 à 14, dans lequel la position définie de l'unité d'actionnement correspond à la position non actionnée d'une pédale de frein connectée à l'unité d'actionnement.

16. Procédé selon au moins une des revendications 10 à 15, dans lequel le capteur comporte au moins un capteur à effet Hall, l'élément indicateur comprenant au moins un aimant permanent.
